(19) Europäisches Patentamt
European Patent Office
Office européen des brevets

(11) **EP 2 848 968 B1**

## (12) EUROPEAN PATENT SPECIFICATION

(45) Date of publication and mention
of the grant of the patent:
**20.02.2019 Bulletin 2019/08**

(51) Int Cl.:
***G02B 5/28*** *(2006.01)*     ***H01S 5/14*** *(2006.01)*

(21) Application number: **13184527.3**

(22) Date of filing: **16.09.2013**

(54) **External cavity laser unit incorporating mid-infrared bandpass interference filter**

Laseranordnung mit externem Resonator mit Mittelbereichs-Infrarot-Bandpassinterferenzfilter

Laser à cavité externe utilisant filtre d'interférence passe-bande à infrarouge moyen

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**18.03.2015 Bulletin 2015/12**

(73) Proprietor: **Humboldt Universität zu Berlin
10099 Berlin (DE)**

(72) Inventors:
 • **Masselink, William Ted
 12205 Berlin (DE)**
 • **Semtsiv, Mykhaylo Petrovych
 10318 Berlin (DE)**
 • **Kischkat, Jan
 12205 Berlin (DE)**

(74) Representative: **Fischer, Uwe
Patentanwalt
Moritzstraße 22
13597 Berlin (DE)**

(56) References cited:
**WO-A1-2012/073791**    **US-A- 4 498 728**
**US-A- 6 038 239**    **US-A1- 2006 193 354**
**US-A1- 2008 298 406**    **US-B1- 6 205 159**
**US-B1- 6 568 105**

 • **SEUNG-HYEON SEONG ET AL: "Characterization
 of External Cavity Laser with Thin Film Narrow
 Bandpass Filter", TRANSPARENT OPTICAL
 NETWORKS, 2007. ICTON '07. 9TH
 INTERNATIONAL CONFERENCE ON, IEEE, PI, 1
 July 2007 (2007-07-01), pages 237-239,
 XP031130727, DOI: 10.1109/ICTON.2007.4296388
 ISBN: 978-1-4244-1248-8**

## Description

The invention relates to an external cavity laser unit according to the preamble of claim 1. Hereinafter, radiation is considered as mid-infrared radiation if its wavelength is between 3 and 30 $\mu$m.

Background of the invention

Prior art external cavity laser units that generate coherent optical radiation typically comprise filters that determine the wavelength of the emitted radiation. In the mid-infrared range, these filters are based on reflection gratings.

Japanese Patent Application JP 2004-053720 discloses a method of fabricating a mid-infrared bandpass interference filter. The method comprises the step of depositing a layer sequence of alternating layers of high refractive index and low refractive index materials on a substrate. The high refractive index and low refractive index materials as well as the substrate are transparent in the mid-infrared range.

US Patent Application Publication US 2008/298 406 A1 discloses an external cavity laser unit according to the preamble of claim 1. More specifically, this publication discloses a compact quantum well based laser system with external cavity configurations that are integrated in a mounting system having high thermal and vibrational stability.

The International Patent Application WO 2012/073 791 A1 discloses an optical functional film for infrared light. The optical functional film comprises an adhesion enhancing layer, which has a film thickness smaller than any one of the plurality of optical function layers. The adhesion enhancing layer is a $Y_2O_3$ layer or an $HfO_2$ layer.

US Patent 4,498,728 A discloses a plurality of infrared transmitting thin layers of substances. The substances are chosen from the group: germanium, zinc selenide, zinc sulfide, chalcogenide glasses, thorium fluoride, yttrium fluoride, and praseodymium fluoride. The layers are applied to an infrared transmitting substrate of a material of the group: germanium, zinc selenide, zinc sulfide and chalcogenide glasses. An intermediate layer is disposed between the thin layers and the infrared transmitting substrate.

Objective of the present invention

An objective of the present invention is to provide an external cavity laser unit comprising a filter having a sufficient mechanical stability for industrial applications.

Brief summary of the invention

An embodiment of the present invention relates to an external cavity laser unit comprising the features of claim 1. Its mid-infrared bandpass interference filter consists of or comprises the following structure:

- (HGLG) repeated n times,
- HGLLG,
- (HGLG) repeated m times,
- H

where

- H is a layer of said high refractive index material,
- L is a layer of said low refractive index material,
  wherein the thickness of the layers of said high refractive index material and the thickness of the layers of said low refractive index material equals a quarter wavelength of the radiation, which is outputted by the external cavity laser, in the respective material, corrected for the angle under which the radiation passes the layers,
- G is an adhesion-promoting layer, and
- n and m are integers.

An advantage of the mid-infrared bandpass interference filter described above is a surprisingly high mechanical stability of the layer sequence. This stability results from adhesion-promoting layers that reliably "glue" the alternating layers of high refractive index and low refractive index materials together. As such, for the first time, it is possible to incorporate mid-infrared bandpass interference filters in industrial applications such as commercial external cavity laser units.

Preferably, the adhesion-promoting layers are arranged between each of the layers of said high refractive index material and the adjacent layers of said low refractive index material.

The thickness of the adhesion-promoting layers is preferably smaller than 10 nm. The adhesion-promoting layers may be oxide layers, preferably $Y_2O_3$-layers. The low refractive index material may be $YF_3$. The high refractive material may be germanium.

n and m are preferably in the range between 2-5.

n preferably equals m.

The filter preferably comprises a substrate that is transparent in the mid-infrared range, preferably a silicon substrate, with antireflection coatings on one surface or on both surfaces. The antireflection coatings preferably consist of $Y_2O_3$.

Preferably the external cavity laser unit comprises a pivoting unit. The pivoting unit may hold the filter and allow pivoting the filter with respect to the propagation direction of the radiation which the laser emits towards the reflector, in order to adjust the transmission range of the filter.

The reflector may be a cat's eye-type reflector. The laser may be a quantum cascade laser.

Brief description of the drawings

In order that the manner in which the above-recited and other advantages of the invention are obtained will be readily understood, a more particular description of the invention briefly described above will be rendered by reference to specific embodiments thereof which are illustrated in the appended figures. Understanding that these figures depict only typical embodiments of the invention and are therefore not to be considered to be limiting of its scope, the invention will be described and explained with additional specificity and detail by the use of the accompanying drawings in which

Figures 1-6 show - in exemplary fashion - fabrication steps for fabricating a mid-infrared bandpass interference filter,

Figure 7 shows the optical transmission through the filter according to Figure 6 as a function of wavenumber,

Figure 8 shows the optical transmission through the filter according to Figure 6, as a function of wavenumber using collimated light,

Figure 9 shows the optical transmission through the filter of Figure 6 for several angles as a function of wavenumber using collimated monochromatic light from a tunable quantum cascade laser,

Figure 10 shows an embodiment of an external cavity laser unit comprising a quantum cascade laser and the filter according to Figure 6, and

Figure 11 shows the optical emission spectrum of the laser unit of Figure 10 as a function of filter angle.

Detailed description of the preferred embodiments

The preferred embodiments of the present invention will be best understood by reference to the drawings, wherein identical or comparable parts are designated by the same reference signs throughout. It will be readily understood that the present invention, as generally described herein, could vary in a wide range. Thus, the following more detailed description of the exemplary embodiments of the present invention, is not intended to limit the scope of the invention, as claimed, but is merely representative of presently preferred embodiments of the invention.

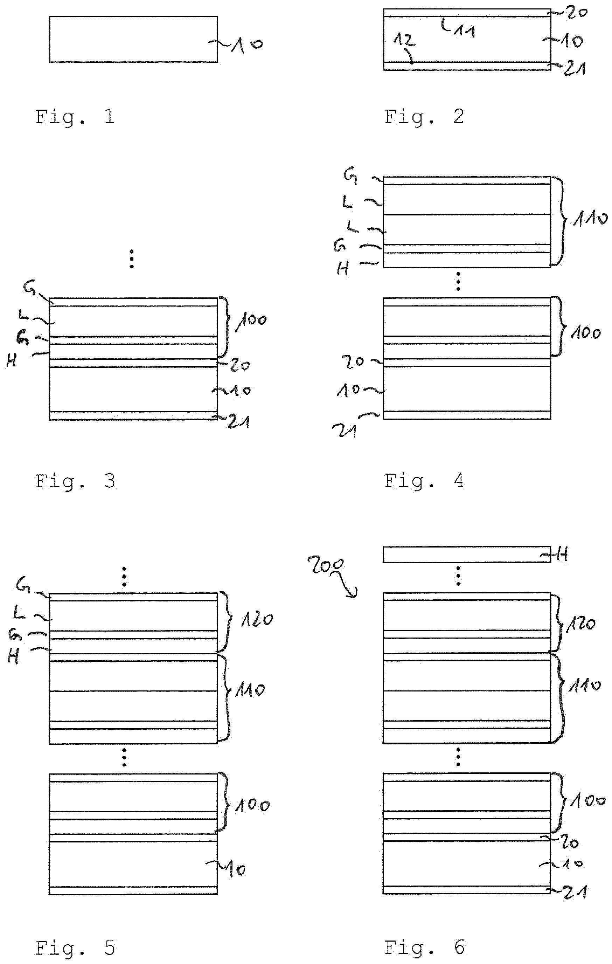

An exemplary embodiment of a method for fabricating a mid-infrared bandpass interference filter will be explained hereinafter with reference to Figures 1-6.

Figure 1 shows a carrier 10 which is transparent for radiation in the mid-infrared range, i. e. for wavelength between 3 and 30 $\mu$m. The carrier 10 may consist of silicon.

The carrier is provided with an antireflection coating 20 and 21 on each of the substrate's surfaces 11 and 12. The antireflection coatings 20 and 21 preferably consist of $Y_2O_3$. The layer thickness of the antireflection coatings 20 and 21 is preferably 595 nm in case of a central filter wavelength of 4.075 $\mu$m.

The antireflection coatings 20 and 21 are preferably deposited by evaporating $Y_2O_3$ with or without plasma and/or ion-beam assist, by sputter deposition, or by chemical vapour deposition. The resulting structure is depicted in Figure 2.

Then, one or more (e. g. 2) HGLG-layer stacks 100 are deposited on the reflection coating 20 as shown in Figure 3. Each HGLG-layer stack 100 comprises a layer H of a high refractive index material, preferably a germanium layer, a layer L of low refractive index material, preferably a $YF_3$-layer, and two adhesion-promoting layers G, preferably $Y_2O_3$-layers.

These layers H, L, G are deposited by evaporating the respective materials subsequently with or without plasma and/or ion-beam assist, by sputter deposition, or by chemical vapour deposition.

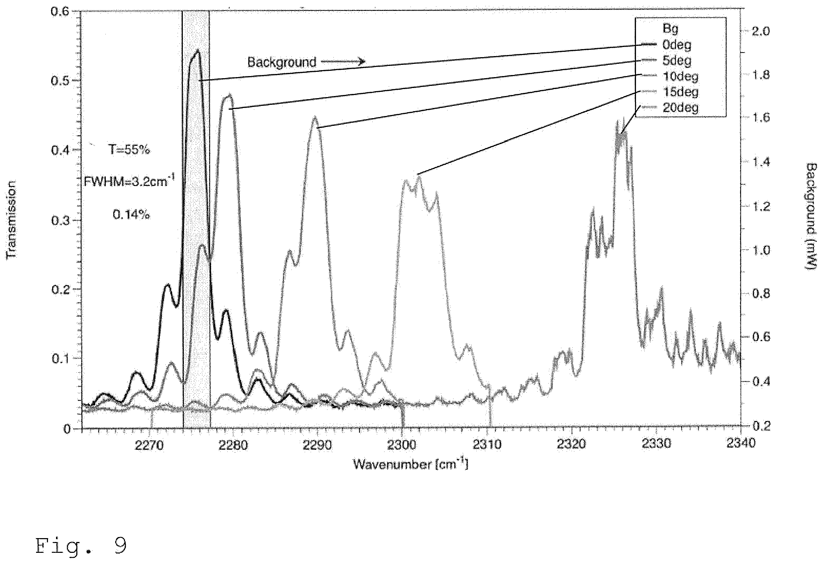

In order to achieve a central filter wavelength of $\lambda c = 4.075$ $\mu$m at a radiation transmission angle $\theta = 55°$ (see Figure 9) the following parameters may be chosen:

Layer H: 258 nm of germanium
Layer L: 769 nm of $YF_3$
Layer G: 5 nm of $Y_2O_3$

The thickness of layers G is preferably so small that the optical behaviour (i.e. central filter wavelength, filter bandwidth and attenuation) is not or at least not significantly influenced by the additional layers G. The purpose of layers G is merely to bond or glue the adjacent layers H and L together. In contrast, layers H and L are meant to determine the optical parameters of the resulting bandpass filter.

Thereafter, Figure 4 shows an HGLLG-layer stack 110 is deposited on the uppermost HGLG-layer stack 100. The materials and layer thicknesses of layer H, layers L and layer G of the HGLLG-layer stack 110 are preferably identical to those of the HGLG-layer stack(s) 100.

On top of the HGLLG-layer stack 110, one or more (e. g. two) HGLG-layer stacks 120 are deposited as can be seen in Figure 5. The materials and layer thicknesses of layer H, layer L and layers G of the HGLG-layer stack(s) 120 are preferably identical to those of the HGLG-layer stack(s) 100.

The layer sequence of the resulting mid-infrared bandpass interference filter 200 is completed by depositing a layer H of high refractive index material, preferably a germanium layer, on top as shown in Figure 6. The thickness of this layer is preferably 258 nm.

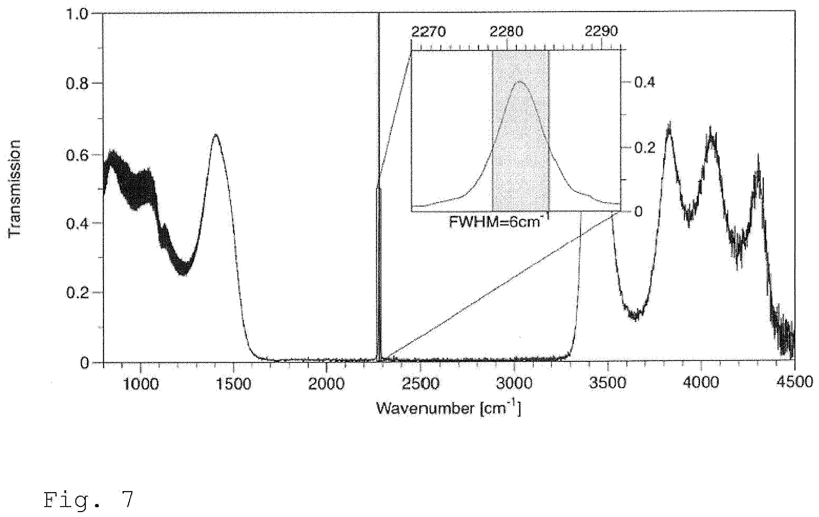

Figure 7 shows the transmission of the filter 200 (see Figure 6) over a wide spectral range using uncollimated light. The data show a very wide opaque region from 1700-3300 $cm^{-1}$, or 3-6 $\mu m$, with a narrow transparent band centred at about 2280 $cm^{-1}$, or 4.38 $\mu m$.

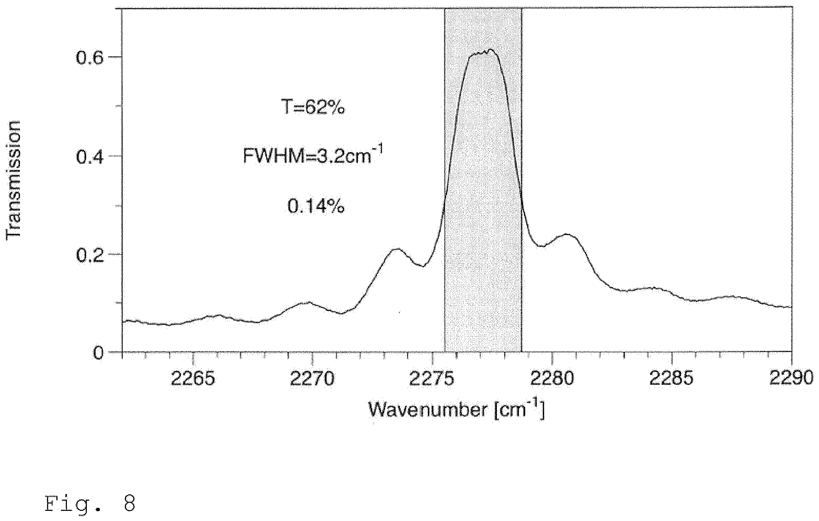

A more precise measurement is made using collimated light as shown in Figure 8. Figure 8 shows that the pass bandwidth is 3.2 $cm^{-1}$, only 0.14% of the position. The maximum transparency is about 60%.

The transparency wavelength depends on the angle of the filter relative to the beam. Figure 9 depicts in exemplary fashion the transmission as a function of wavenumber for several filter angles. It is clear that the passband is tuned over about 2% using angles between 0 and 20°. The gray curve shows the emission power as a function of wavenumber. The power dips are due to $CO_2$ absorption in the ambient atmosphere.

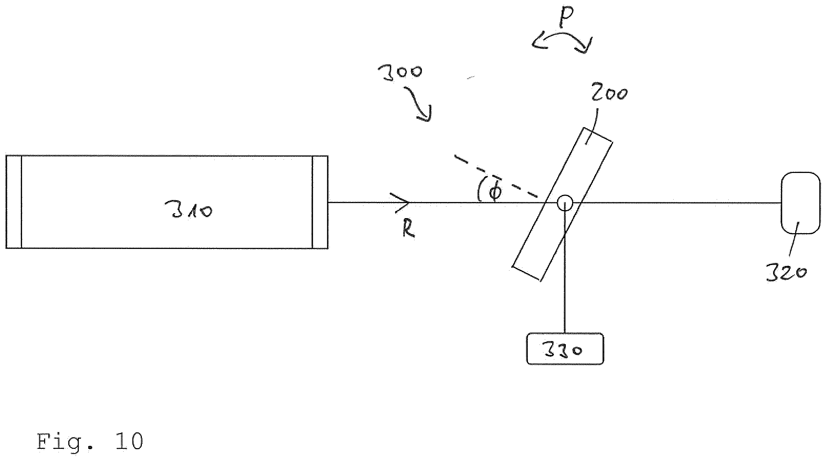

Figure 10 shows an exemplary embodiment of an external cavity laser unit 300 comprising: a laser 310 (e. g. a quantum cascade laser) capable of generating coherent optical radiation in the mid-infrared range, the mid-infrared bandpass interference filter 200 according to Figure 6, and a reflector 320 (e. g. a cat's eye-type reflector). The mid-infrared bandpass interference filter 200 is arranged between the laser 310 and the reflector 320.

The external laser unit 300 further comprises a pivoting unit 330, which holds the filter 200 and allows pivoting the filter 200 with respect to the propagation direction of the radiation R which the laser 310 emits towards the reflector 320. By tilting the filter along arrow P by an angle θ (e.g. θ = 55° as mentioned above), the transmission range of the filter 200 and the central wavelength of the filter 200 may be influenced and/or controlled.

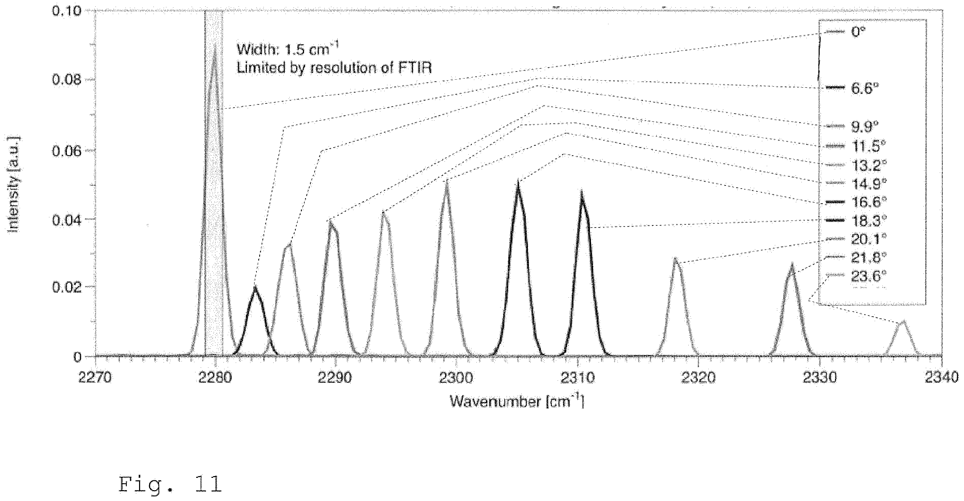

Figure 11 shows the emission of the external laser unit 300 as a function of wavenumber for several tuning angles φ. It is apparent that the emission wavelength can be tuned by changing the filter angle φ.

The thickness of the layers H and L equals a quarter wavelength of the radiation, which the external cavity laser unit is supposed to generate and output, in the respective material, corrected for the angle θ under which the radiation passes the layers.

Preferably, the filter 200 is designed in such a way that it allows tuning in both directions around the central wavelength λc thus the design angle θc is an oblique one, preferably 20° or 30°, not normal. Then the layer thicknesses may be determined by the equations

$$d_H = \frac{\lambda_c}{4R_e(n_H)\cos(\arcsin(\sin\theta_c / R_e(n_H)))}$$

$$d_L = \frac{\lambda_c}{4R_e(n_L)\cos(\arcsin(\sin\theta_c / R_e(n_L)))}$$

$$d_I = \frac{\lambda_c}{4R_e(n_I)\cos(\arcsin(\sin\theta_c / R_e(n_I)))}$$

where $n_H$ and $n_L$ are the refractive indices of layers H and L (see Figures 1-6). $n_I$ is the refractive index of antireflection layers 20 and 21 (see Figures 2-6).

Then the transmission wavelength tunes with angle θ according to the formula:

$$\lambda(\theta) = \lambda(0)\sqrt{1 - \sin^2\theta / n_{eff}^2}$$

and the effective (or average) refractive index is:

$$n_{eff} \approx n_L / \sqrt{1 - (n_L/n_H) + (n_L/n_H)^2} \ \ .$$

In summary, the embodiments described above comprise an infrared optical filter that may have high (over 50%) transmission in a very narrow range around a central wavelength in the infrared (between 3 and 30 μm), which is inside a wide range with very low (under 5%) transmission. The width of the high transmission range may be less than 0.5% of the value of the central wavelength. The width of the blocking range may be at least 50% of the value of the central wavelength.

Also, the position of the transmission range can be tuned by at least 5% of the central wavelength by tilting it about an axis that is normal to the optical axis. This results in an extremely narrow width of the transmission band while maintaining its high level of transmissivity and tunability.

The band interference filter described above may be used as a replacement of a diffraction grating in an External Resonator (External Cavity, EC) setup for a coherent infrared source such as the Quantum Cascade Laser (QCL), allowing the laser to stably oscillate on a single laser mode selected by the transmission line of the filter. The two advantages of using an interference filter as opposed to a diffraction grating are:

- the greatly increased angular dispersion of such filters allowing for more sensitive tuning with a given tilt angle and more stable single-mode operation, and
- the freedom to use a "cat's eye"-type retro-reflector that reflects the incident beam collinear to itself, regardless of angle of incidence making the setup effectively self-aligning and misalignment-insensitive.

Reference Signs

| 10 | carrier/substrate |
| 11 | surface |
| 12 | surface |
| 20 | antireflection coating |
| 21 | antireflection coating |
| 100 | HGLG-layer stack |
| 110 | HGLLG-layer stack |
| 120 | HGLG-layer stack |
| 200 | filter |
| 300 | external laser unit |
| 310 | laser |
| 320 | reflector |
| 330 | pivoting unit |

| G | adhesion-promoting layer |
| H | layer |
| L | layer |
| P | rotational motion of pivoting unit |

R  radiation

**Claims**

1. External cavity laser unit (300) comprising a laser (310) capable of generating coherent optical radiation (R) in the mid-infrared range, a filter, and a reflector (320), wherein said filter (200) is arranged between the laser (310) and the reflector (320),
**characterized in that**
said filter is a mid-infrared bandpass interference filter (200) comprising a layer sequence (100, 110, 120) of alternating layers of high refractive index and low refractive index materials, said high refractive index and low refractive index materials being transparent in the mid-infrared range,
wherein an adhesion-promoting layer (G) is arranged between at least one layer of said high refractive index material and the adjacent layer of said low refractive index material, and
wherein the filter (200) consists of or comprises the following structure:

   - (HGLG) repeated n times,
   - HGLLG,
   - (HGLG) repeated m times,
   - H

   where

   - H is a layer of said high refractive index material,
   - L is a layer of said low refractive index material,

   wherein the thickness of the layers (H) of said high refractive index material and the thickness of the layers (L) of said low refractive index material equals a quarter wavelength of the radiation (R), which is outputted by the external cavity laser (310), in the respective material, corrected for the angle under which the radiation (R) passes the layers,

   - G is an adhesion-promoting layer, and
   - n and m are integers.

2. The external cavity laser unit (300) according to claim 1, **characterized in that**
the thickness of the adhesion-promoting layers (G) is smaller than 10 nm.

3. The external cavity laser unit according to any of the preceding claims,
**characterized in that**
the adhesion-promoting layers (G) are oxide layers.

4. The external cavity laser unit according to any of the preceding claims,
**characterized in that**
the adhesion-promoting layers (G) are $Y_2O_3$-layers.

5. The external cavity laser unit according to any of the preceding claims,
**characterized in that**
the low refractive index material is $YF_3$.

6. The external cavity laser unit according to any of the preceding claims,
**characterized in that**
the high refractive material is germanium.

7. The external cavity laser unit according to claim 1,
**characterized in that** the adhesion-promoting layers (G) are arranged between each of the layers of said high refractive index material and the adjacent layers of said low refractive index material.

8. The external cavity laser unit according to any of the preceding claims,
**characterized in that**

the filter (200) comprises a substrate (10) transparent in the mid-infrared range, preferably a silicon substrate, with one or more antireflection coatings (20, 21) on one side or on both sides (11, 12), the one or more antireflection coatings (20, 21) preferably consisting of $Y_2O_3$.

9. The external cavity laser unit (300) according to any of the preceding claims, **characterized in that**

- the external laser unit (300) comprises a pivoting unit (330),
- said pivoting unit (330) holding the filter (200) and allowing pivoting of the filter (200) with respect to a propagation direction of the radiation (R) which the laser (310) emits towards the reflector (320), in order to adjust a transmission range of the filter (200).

10. The external cavity laser unit (300) according to any of the preceding claims, **characterized in that** the reflector (320) is a cat's eye-type reflector.

11. The external cavity laser unit (300) according to any of the preceding claims, **characterized in that** said laser (310) is a quantum cascade laser.

**Patentansprüche**

1. Laseranordnung mit externem Hohlraum (300), umfassend einen Laser (310), der kohärente optische Strahlung (R) im mittleren Infrarotbereich generieren kann, ein Filter und einen Reflektor (320), wobei das Filter (200) zwischen dem Laser (310) und dem Reflektor (320) angeordnet ist, **dadurch gekennzeichnet, dass** das Filter ein Mittelbereichs-Infrarot-Bandpassinterferenzfilter (200) ist, umfassend eine Schichtfolge (100, 110, 120) von alternierenden Schichten aus Materialien mit hohem Brechungsindex und Materialien mit niedrigem Brechungsindex, wobei die Materialien mit hohem Brechungsindex und Materialien mit niedrigem Brechungsindex im mittleren Infrarotbereich transparent sind;

wobei eine Haftvermittlerschicht (G) zwischen mindestens einer Schicht des Materials mit hohem Brechungsindex und der benachbarten Schicht aus Material mit niedrigem Brechungsindex angeordnet ist, und

wobei das Filter (200) aus der folgenden Struktur besteht oder diese umfasst:

- (HGLG), n Mal wiederholt,
- HGLLG,
- (HGLG), m Mal wiederholt,
- H

wobei

- H eine Schicht aus dem Material mit hohem Brechungsindex ist,
- L eine Schicht aus dem Material mit niedrigem Brechungsindex ist, wobei die Dicke der Schichten (H) des Materials mit hohem Brechungsindex und die Dicke der Schichten (L) des Materials mit niedrigem Brechungsindex gleich einer Viertelwellenlänge der Strahlung (R), die durch den Laser mit externem Hohlraum (310) ausgegeben wird, in dem jeweiligen Material ist, korrigiert auf den Winkel, mit dem die Strahlung (R) die Schichten durchläuft,
- G eine Haftvermittlerschicht ist, und
- n und m ganze Zahlen sind.

2. Lasereinheit mit externem Hohlraum (300) nach Anspruch 1, **dadurch gekennzeichnet, dass** die Dicke der Haftvermittlerschichten (G) kleiner als 10 nm ist.

3. Lasereinheit mit externem Hohlraum nach einem der vorhergehenden Ansprüche, **dadurch gekennzeichnet, dass** die Haftvermittlerschichten (G) Oxidschichten sind.

4. Lasereinheit mit externem Hohlraum nach einem der vorhergehenden Ansprüche, **dadurch gekennzeichnet, dass** die Haftvermittlerschichten (G) $Y_2O_3$-Schichten sind.

5. Lasereinheit mit externem Hohlraum nach einem der vorhergehenden Ansprüche, **dadurch gekennzeichnet, dass** das Material mit niedrigem Brechungsindex $YF_3$ ist.

6. Lasereinheit mit externem Hohlraum nach einem der vorhergehenden Ansprüche, **dadurch gekennzeichnet, dass** das Material mit hohem Brechungsindex Germanium ist.

7. Lasereinheit mit externem Hohlraum nach Anspruch 1, **dadurch gekennzeichnet, dass** die Haftvermittlerschichten (G) zwischen jeder der Schichten des Materials mit hohem Brechungsindex und der benachbarten Schichten des Materials mit niedrigem Brechungsindex angeordnet sind.

8. Lasereinheit mit externem Hohlraum nach einem der vorhergehenden Ansprüche, **dadurch gekennzeichnet, dass** das Filter (200) ein Substrat (10) umfasst, das im mittleren Infrarotbereich transparent ist, vorzugsweise ein Siliciumsubstrat mit einer oder mehreren Antireflexionsbeschichtungen (20, 21) auf einer Seite oder auf beiden Seiten (11, 12), wobei die eine oder mehreren Antireflexionsbeschichtungen (20, 21) vorzugsweise aus $Y_2O_3$ bestehen.

9. Lasereinheit mit externem Hohlraum (300) nach einem der vorhergehenden Ansprüche, **dadurch gekennzeichnet, dass**

   - die externe Lasereinheit (300) eine Schwenkeinheit (330) umfasst,
   - wobei die Schwenkeinheit (330) das Filter (200) hält und Schwenken des Filters (200) in Bezug auf eine Ausbreitungsrichtung der Strahlung (R) ermöglicht, die der Laser (310) in Richtung des Reflektors (320) emittiert, um einen Übertragungsbereich des Filters (200) anzupassen.

10. Lasereinheit mit externem Hohlraum (300) nach einem der vorhergehenden Ansprüche, **dadurch gekennzeichnet, dass** der Reflektor (320) ein Reflektor vom Typ Katzenauge ist.

11. Lasereinheit mit externem Hohlraum (300) nach einem der vorhergehenden Ansprüche, **dadurch gekennzeichnet, dass** der Laser (310) ein Quantenkaskadenlaser ist.

**Revendications**

1. Unité laser à cavité externe (300) comprenant un laser (310) capable de générer un rayonnement optique cohérent (R) dans l'infrarouge moyen, un filtre et un réflecteur (320), où ledit filtre (200) est agencé entre le laser (310) et le réflecteur (320), **caractérisée en ce que** :

   ledit filtre est un filtre d'interférence passe-bande dans l'infrarouge moyen (200) comprenant une séquence de couches (100, 110, 120) de couches alternées de matériaux à indice de réfraction élevé et à faible indice de réfraction, lesdits matériaux à indice de réfraction élevé et à faible indice de réfraction étant transparents dans l'infrarouge moyen,
   où une couche favorisant l'adhérence (G) est disposée entre au moins une couche dudit matériau à indice de réfraction élevé et la couche adjacente dudit matériau à faible indice de réfraction, et
   où le filtre (200) consiste en, ou comprend, la structure suivante :

      - (HGLG) répété n fois,
      - HGLLG,
      - (HGLG) a répété m fois,
      - H

   où

      - H est une couche dudit matériau à indice de réfraction élevé,
      - L est une couche dudit matériau à faible indice de réfraction,

   où l'épaisseur des couches (H) dudit matériau à indice de réfraction élevé et l'épaisseur des couches (L) dudit matériau à faible indice de réfraction est égale à un quart de la longueur d'onde du rayonnement (R), qui est émis par le laser à cavité externe (310), dans le matériau respectif ; épaisseur corrigée pour l'angle suivant lequel le rayonnement (R) traverse les couches,

- G est une couche favorisant l'adhérence, et
- n et m sont des entiers.

2. Unité laser à cavité externe (300) selon la revendication 1,
**caractérisée en ce que** l'épaisseur des couches favorisant l'adhérence (G) est inférieure à 10 nm.

3. Unité laser à cavité externe selon l'une quelconque des revendications précédentes,
**caractérisée en ce que** les couches favorisant l'adhérence (G) sont des couches d'oxyde.

4. Unité laser à cavité externe selon l'une quelconque des revendications précédentes,
**caractérisée en ce que** les couches favorisant l'adhérence (G) sont des couches de $Y_2O_3$.

5. Unité laser à cavité externe selon l'une quelconque des revendications précédentes,
**caractérisée en ce que** le matériau à faible indice de réfraction est du $YF_3$.

6. Unité laser à cavité externe selon l'une quelconque des revendications précédentes,
**caractérisée en ce que** le matériau hautement réfractif est le germanium.

7. Unité laser à cavité externe selon la revendication 1,
**caractérisée en ce que** les couches favorisant l'adhérence (G) sont disposées entre chacune des couches dudit matériau à indice de réfraction élevé et des couches adjacentes dudit matériau à faible indice de réfraction.

8. Unité laser à cavité externe selon l'une quelconque des revendications précédentes,
**caractérisée en ce que** le filtre (200) comprend un substrat (10) transparent dans l'infrarouge moyen, de préférence un substrat en silicium, avec un ou plusieurs revêtements antireflet (20, 21) sur un côté ou sur les deux côtés (11, 12), les un ou plusieurs revêtements antireflet (20, 21) étant de préférence constitués de $Y_2O_3$.

9. Unité laser à cavité externe (300) selon l'une quelconque des revendications précédentes,
**caractérisée en ce que** :

- l'unité laser externe (300) comprend une unité pivotante (330),
- ladite unité pivotante (330) maintenant le filtre (200) et permettant le pivotement du filtre (200) par rapport à une direction de propagation du rayonnement (R) que le laser (310) émet vers le réflecteur (320), afin de régler la plage de transmission du filtre (200) .

10. Unité laser à cavité externe (300) selon l'une quelconque des revendications précédentes,
**caractérisée en ce que** le réflecteur (320) est un réflecteur de type oeil de chat.

11. Unité laser à cavité externe (300) selon l'une quelconque des revendications précédentes,
**caractérisée en ce que** ledit laser (310) est un laser à cascade quantique.

Fig. 1

Fig. 2

Fig. 3

Fig. 4

Fig. 5

Fig. 6

Fig. 7

EP 2 848 968 B1

Fig. 8

Fig. 9

Fig. 10

Fig. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004053720 A
- US 2008298406 A1
- WO 2012073791 A1
- US 4498728 A